# EUROPEAN PATENT APPLICATION

(11) **EP 2 293 510 A2**
(43) Date of publication of application: **09.03.2011**
(21) Application number: 10196704.0
(22) Date of filing: 14.11.2008
(51) Int. Cl.: H04L 27/34, H04L 27/26, H04L 27/10, H04L 1/00

(54) **Method and system for transmitting and receiving signals**

(30) Priority: 14.11.2007 US 988072 P
(62) Divisional of application: 08848932.3
(71) Applicant: LG ELECTRONICS INC., Yeongdeungpo-gu Seoul 150-721 (KR)
(72) Inventor: Ko, Woo Suk, 137-724, Seoul (KR); Moon, Sang Chul, 137-724, Seoul (KR)
(74) Representative: Cabinet Plasseraud

(57) **Abstract**

The present invention relates to methods of efficiently transmitting signals, an efficient receiver, and methods of efficiently receiving the signals. In particular, the present invention relates to a receiver and receiving methods regarding adjusting an hybrid modulation ratio. In addition, the present invention relates to methods of efficiently transmitting signals which are counterparts of the receiving methods.

## Description

### Technical Field

The present application claims the benefit of priority under 35 U.S.C. 119 of U.S. provisional patent application No. 60/988,072 filed on Nov. 14, 2007, which is hereby expressly incorporated by reference.

The present invention relates to a method of efficiently transmitting and receiving signals and efficient transmitter and receiver for an OFDM (Orthogonal Frequency Division Multiplexing) system including a TFS (Time-Frequency Slicing).

### Background Art

TFS (Time Frequency Slicing) technique has been introduced for broadcasting. When a TFS is used, a single service can be transmitted through multiple RF (Radio Frequency) channels on a two-dimensional time-frequency space.

OFDM (Orthogonal Frequency Division Multiplexing) is a frequency-division multiplexing (FDM) scheme utilized as a digital multi-carrier modulation method. A large number of closely-spaced orthogonal sub-carriers are used to carry data. The data are divided into several parallel data streams or channels, one for each sub-carrier. Each sub-carrier is modulated with a conventional modulation scheme (such as quadrature amplitude modulation or phase shift keying) at a low symbol rate, maintaining total data rates similar to conventional single-carrier modulation schemes in the same bandwidth.

OFDM has developed into a popular scheme for wideband digital communication, whether wireless or over copper wires, used in applications such as digital television and audio broadcasting, wireless networking and broadband internet access.

When TFS, which uses multiple RF bands for each transmitter is combined with OFDM, frequency diversity gain and statistical multiplexing gain can be obtained, thus, resources can be efficiently utilized.

### Disclosure of Invention

### Technical Problem

It is, therefore, an object of the present invention to provide a method of efficiently transmitting and receiving signals and efficient transmitter and receiver for an OFDM system including TFS.

### Technical Solution

According to an aspect of the present invention, there is provided a method of transmitting signals for an OFDM (Orthogonal Frequency Division Multiplexing) system including TFS (Time Frequency Slicing), comprising: encoding bitstreams; performing a hybrid modulation on the encoded bitstreams to transform the encoded bitstreams into symbols; adjusting a hybrid modulation ratio of the hybrid modulation such that a GCD (Greatest Common Divisor) of a predetermined number of symbols outputted from the hybrid modulation using the predetermined number of constellation type is expressed as an integer multiplied by an LCM (Least Common Multiple) of each index number of a predetermined number of transmitters; and encoding the symbols into a multiple signal or a single signal.

According to another aspect of the present invention, there is provided a receiver for an OFDM system including TFS, comprising: a demodulator configured to transform received signals into OFDM symbols; a symbol splitter configured to split the OFDM symbols according to a predetermined hybrid modulation ratio set by transmitters; a demapper configured to transform the splitted OFDM symbols into bitstreams; and a decoder configured to correct errors in the bitstreams.

According to yet another aspect of the present invention, there is provided a method of receiving signals for an OFDM system including TFS, comprising: transforming received signals into OFDM symbols; splitting the OFDM symbols according to a predetermined hybrid modulation ratio set by transmitters; transforming the splitted OFDM symbols into bitstreams; and correcting errors in the bitstreams.

It is to be understood that both the foregoing general description and the following detailed description of the present invention are exemplary and explanatory and are intended to provide further explanation of the invention as claimed.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

### Advantageous Effects

According to the present invention, it is possible to provide a method of efficiently transmitting and receiving signals and efficient transmitter and receiver for an OFDM system including TFS.

### Brief Description of the Drawings

The accompanying drawings, which are included to provide a further understanding of the invention and are incorporated in and constitute a part of this application, illustrate embodiment(s) of the invention and together with the description serve to explain the principle of the invention. In the drawings:

Fig. 1 is a block diagram of an example of a TFS (Time Frequency Slicing)-OFDM (Orthogonal Frequency Division Multiplexing) transmitter.

Fig. 2 is a block diagram of an example of the input processor shown in the Fig. 1.

Fig. 3 is a block diagram of an example of the BICM (Bit-Interleaved Coding and Modulation) shown in Fig. 1.

Fig. 4 is a block diagram of an example of the Frame Builder shown in Fig. 1.

Fig. 5 is a table of an example of a hybrid modulation ratio when an LDPC block length is 64800 bits.

Fig. 6 is a table of an example of a hybrid modulation ratio when an LDPC block length is 16200 bits.

Fig. 7 shows an example of a hybrid ratio that can be used when LDPC block length is 16200.

Fig. 8 shows an example of hybrid ratios used in Fig. 7 being used when LDPC block length is 64800.

Fig. 9 is a block diagram of an example of the QAM mapper shown in Fig. 1.

Fig. 10 is a block diagram of an example of the QAM mapper combined with an inner encoder and an inner interleaver.

Fig. 11 is an example of HOQ/LOQ power calibrations applied to QAM mappers using hybrid modulation.

Fig. 12 is an example of HOQ/LOQ power calibration applied to QAM mapper which is combined with inner interleaver.

Fig. 13 is an example of a bit interleaver.

Fig. 14 is a table of an example of the bit interleaver when an LDPC block length is 64800 bits.

Fig. 15 is a table of an example of the bit interleaver when an LDPC block length is 16200 bits.

Fig. 16 is an example of the demux shown in Fig. 1.

Fig. 17 is another example of the demux shown in Fig. 1.

Fig. 18 shows six example of demultiplexer. Each of the examples shows a method of assigning different reliability to bits located in column of bit-interleaver.

Fig. 19 shows an example of a demultiplexer. It is a structure appropriate for being used with FEC which has various characteristics for each code rate such as irregular LDPC.

Fig. 20 shows an example of a DEMUX selection signal.

Fig. 21 is a relationship between an input bitstream of the bit interleaver and an output bitstream of the demux.

Fig. 22 is an example of a QAM symbol mapping.

Fig. 23 is a block diagram of an example of the MIMO/MISO decoder shown in Fig. 1.

Fig. 24 is a block diagram of an example of the modulator, specifically an example of an OFDM modulator.

Fig. 25 is a block diagram of an example of the analog processor shown in Fig. 1.

Fig. 26 is a block diagram of an example of a TFS-OFDM receiver.

Fig. 27 is a block diagram of an example of the AFE (Analog Front End) shown in Fig. 26.

Fig. 28 is a block diagram of an example of the demodulator, specifically an OFDM demodulator.

Fig. 29 is a block diagram of an example of the MIMO/MISO decoder shown in Fig. 26.

Fig. 30 is a block diagram of an example of the frame parser shown in Fig. 26.

Fig. 31 is a block diagram of an example of the QAM demapper shown in Fig. 30.

Fig. 32 is a block diagram of an example of the QAM demapper combined with an inner deinterleaver.

Fig. 33 shows an example of QAM demapper which is a counterpart of the Fig. 11.

Fig. 34 shows an example of QAM demapper combined with innter deinterleaver which is a counterpart of the Fig. 12.

Fig. 35 shows an example of multiplexer which is a counterpart of Fig. 19.

Fig. 36 is a block diagram of an example of the BICM decoder shown in Fig. 26.

Fig. 37 is a block diagram of an example of the output processor shown in Fig. 26.

### Best Mode for Carrying Out the Invention

Reference will now be made in detail to the preferred embodiments of the present invention, examples of which are illustrated in the accompanying drawings. Wherever possible, the same reference numbers will be used throughout the drawings to refer to the same or like parts.

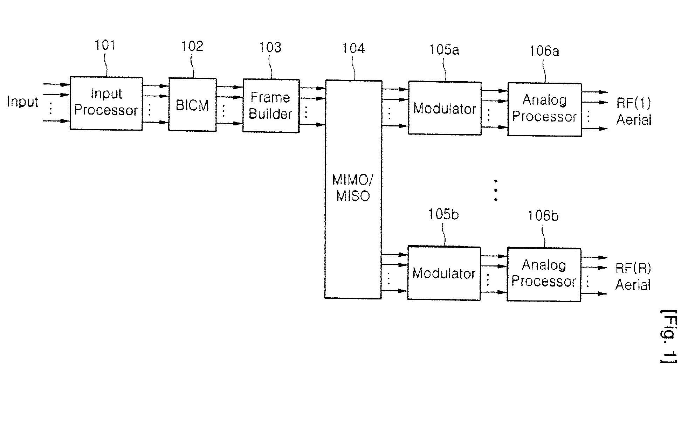

Fig. 1 shows an example of proposed TFS (Time Frequency Slicing)-OFDM (Orthogonal Frequency Division Multiplexing) transmitter. A multiple MPECr2-TS (Transport Stream) and a multiple Generic stream can be inputted into a TFS transmitter. The input processor (101) can split the inputted streams into a multiple output signals for a multiple PLP (Physical Layer Path). The BICM (Bit-Interleaved Coding and Modulation) (102) can encode and interleave the PLP individually. The frame builder (103) can transform the PLP into total R of RF bands. MIMO (Multiple-Input Multiple-Output)/MISO (Multiple-Input Single-Output) (104) technique can be applied for each RF band. Each RF band for each antenna can be individually modulated by the modulator (105a, b) and can be transmitted to antennas after being converted to an analog signal by the analog processor (106a, b).

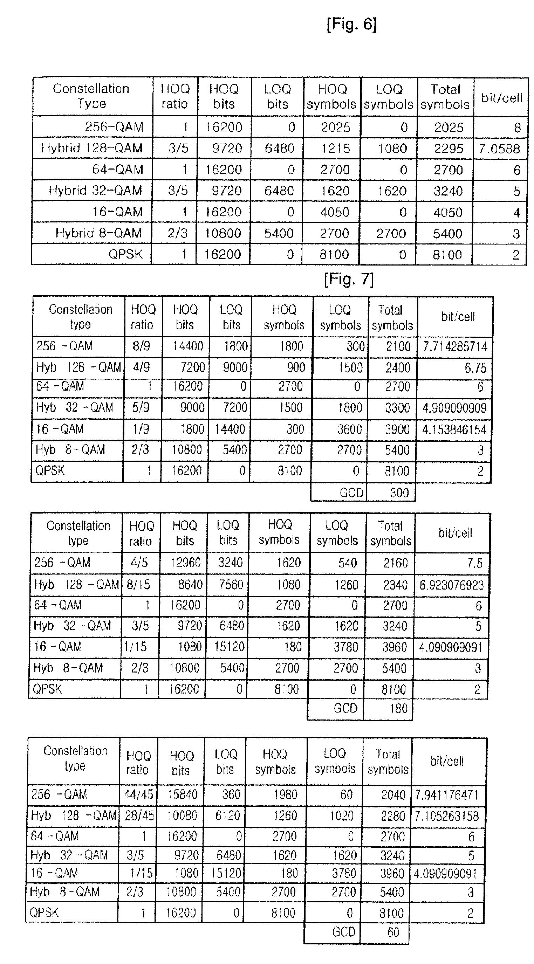

Fig. 7 shows an example of a hybrid ratio that can be used when LDPC block length is 16200.

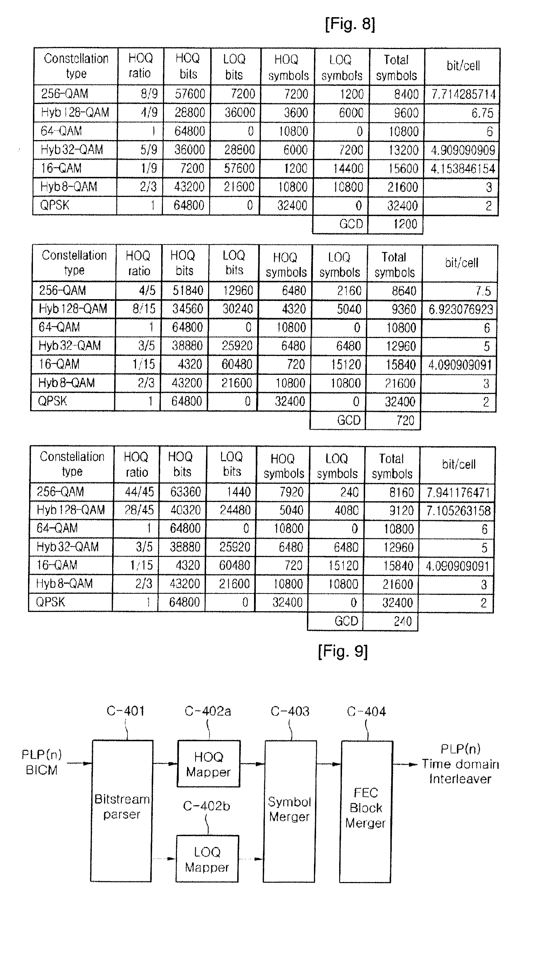

Fig. 8 shows an example of hybrid ratios used in Fig. 7 being used when LDPC block length is 64800.

### Mode for the Invention

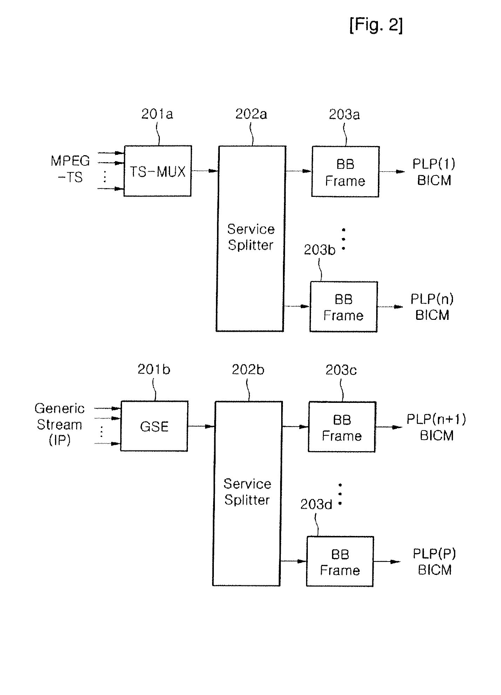

Fig. 2 is an example of the input processor. MPEG-TS (Transport Stream) can be multiplexed into a single output through TS-MUX (201a) and Generic streams (Internet protocol) can be transformed into a single output through GSE (General Stream Encapsulation) (201b). Each output from the TS-MUX and GSE can be split for multiple services by the service splitter (202a, b). PLP is a processing of each service. Each PLP can be transformed into a frame by the BB (Baseband) Frame (103a-d).

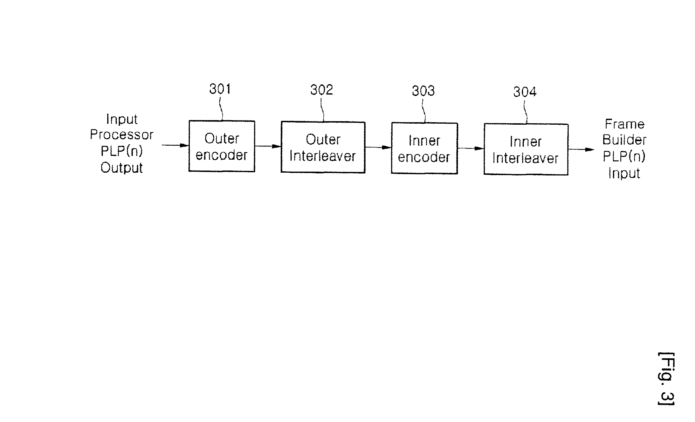

Fig. 3 is an example of the BICM. The Outer encoder (301) and the inner encoder (303) can add redundancy for error correction in a transmission channel. The outer interleaver (302) and the inner interleaver (304) can interleave data randomly to mitigate burst errors.

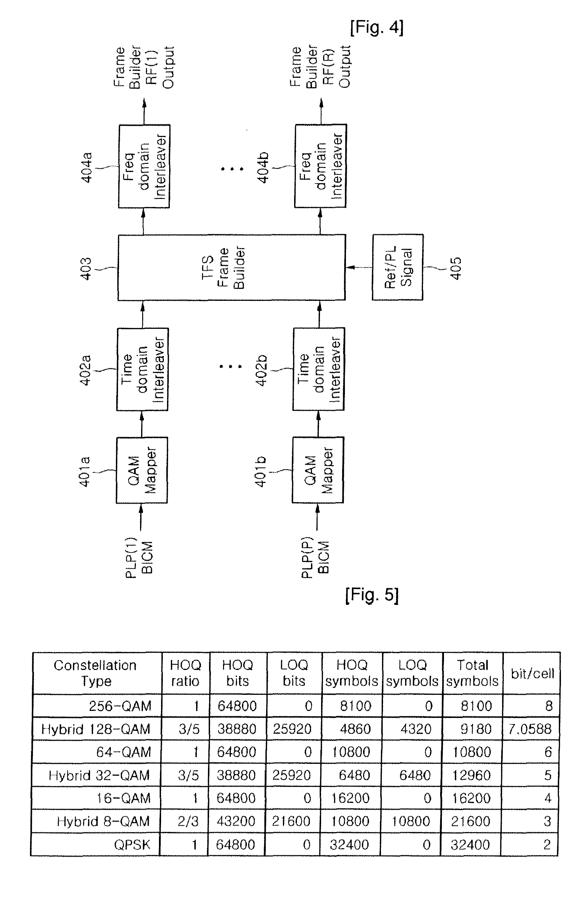

Fig. 4 is an example of the frame builder. QAM mapper (401a, b) can transform inputted bits into QAM symbols. Hybrid QAM can be used. Time domain interleaver (402a, b) can interleave data in time domain to make the data be robust against burst error. At this point, an effect of interleaving many RF bands can be obtained in a physical channel because the data are going to be transmitted to a multiple RF bands. TFS frame builder (403) can split inputted data to form TFS frames and send the TFS frames to total R of RF bands according to a TFS scheduling. Each RF band can be individually interleaved in frequency domain by frequency domain interleaver (404a, b) and can become robust against frequency selective fading. Ref (Reference Signals), PL (Physical Layer) signaling, and pilots can be inserted when the TFS frame is built (405).

By hybriding two Even-QAMs, which transmits even number of bits per QAM symbol, an Odd-QAM, which transmits odd number of bits per QAM symbol can be formed by a Hybrid QAM mapper. For example, hybrid 128-QAM can be obtained by hybriding 256-QAM and 64-QAM, hybrid 32-QAM can be obtained by hybriding 64-QAM and 16-QAM, and hybrid 8-QAM can be obtained by hybriding 16-QAM and 4-QAM.

Figs. 5 and 6 show examples of a hybrid ratio when DVB-S2 LDPC (Low Density Parity Check) code is used as an inner code. The first column on the table represents constellation type. HOQ (Higher-Order QAM) ratio represents a ratio for higher-order QAM between two QAM types. LOQ (Lower-Order QAM) ratio is 1-HOQ ratio. Hybrid QAM can be obtained by two adjacent Even-QAMs. For example, hybrid 128-QAM (bit/cell=7) is obtained by hybriding 256-QAM and 64-QAM. HOQ bits and LOQ bits represent number of bits used for mapping into HOQ symbol and LOQ symbol respectively in one LDPC block. HOQ symbols and LOQ symbols represent number of symbols after symbol mapping. Total symbol is a sum of the HOQ symbols and the LOQ symbols. The last column on the table represents effective number of bits transmitted per QAM symbol. As seen on the table, only Hybrid 128-QAM shows a slight difference from 7 bit/cell.

Fig. 6 shows a case when LDPC block length is 16200 bits. When a scheduling is performed to evenly distribute QAM symbols, which are generated by the Frame Builder, to RF bands of TFS system, the value of the total symbols should be divisible by a least common multiple of each index number of RF band. For example, if six RF bands are allowed, then the value of total symbols on the table should be divisible by a least common multiple of 1 through 6, i.e., 60. For the case shown in Fig. 5, it is divisible. However, for the case shown in Fig. 6, it is not divisible. If LDPC block length is 16200 bits as shown in Fig. 6, the total symbols on the table can be made divisible by 60 by combining four of the LDPC blocks into a single LDPC block having a length of 64800 as in Fig. 5.

Hybrid ratio can be adjusted to accommodate a scheduling by frame builder which evenly distributes QAM symbols to RF bands used in TFS system.

Fig. 7 shows an example of a hybrid ratio that can be used when LDPC block length is 16200. According to a first example or the example shown on top of Fig. 7, greatest common divisor(GCD) of the Total symbols (cell) is 300, thus, can be divided by 60 and symbols can be evenly distributed to each RF band. In addition, by defining five symbols (cell) as a slot, overhead required to address each symbol (cell) can be reduced.

According to a second example or the example shown in the middle of Fig. 7, GCD of total symbol is 180, which is divisible by 60, thus, symbols can be evenly distributed to each RF band. In addition, by defining three symbols (cell) as a slot, overhead required to address each symbol (cell) can be reduced. According to a last example or the example shown at the bottom of Fig. 7, GCD of total symbol is 60, thus, symbols can be evenly distributed to each RF band.

Fig. 8 shows an example of hybrid ratios used in Fig. 7 being used when LDPC block length is 64800. As in Fig. 7, GCD of total symbols shown in the three examples in Fig. 8 can be divided by 60, thus, symbols can be evenly distributed to each RF band. In addition, by defining twenty symbols as a slot as shown in the top, by defining twelve symbols as a slot as shown in the middle, or by defining four symbols as a slot as shown at the bottom, addressing overhead can be reduced.

Fig. 9 shows an example of QAM mapper using hybrid modulation. Bit stream parser(c-401) can parse inputted bitstreams into HOQ mapper(c-402a) and LOQ mapper(c-402b). The symbol merger(c-403) can merge the two inputted symbol streams into a single symbol stream. FEC (Forward Error Correction) block merger (c-404), for example, can combine four of bit symbol blocks having a length of 16200 into a single block having a length of 64800.

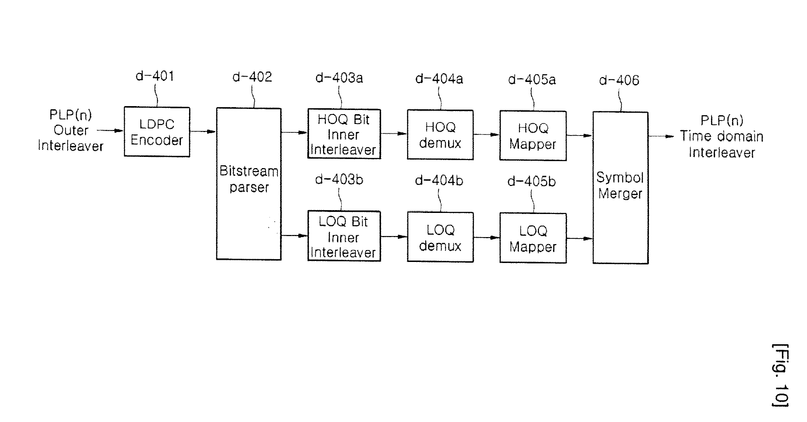

Fig. 10 shows an example of QAM mapper combined with inner interleavers. Bitstreams can be divided by bitstream parser (d-402) into bitstreams for HOQ and LOQ mappers. Each bitstream goes through bit interleaving (d-403a, d-403b) and demux (d-404a, d-404b) processes. Throughout these processes, characteristics of LDPC codeword and constellation reliability can be combined. Each output can be converted into symbolstreams by the HOQ and LOQ mappers (d-405a, d-405b), then merged into a single symbolstream by the symbol merger (d-406).

Where an hybrid modulation is used, improved performance can be achieved by adjusting signal power of HOQ (Higher-order QAM) differently from power of LOQ(Lower-order QAM). To differentiate the powers, a power calibration, which applies different power to each of the QAM mapper of the hybrid modulation, can be used.

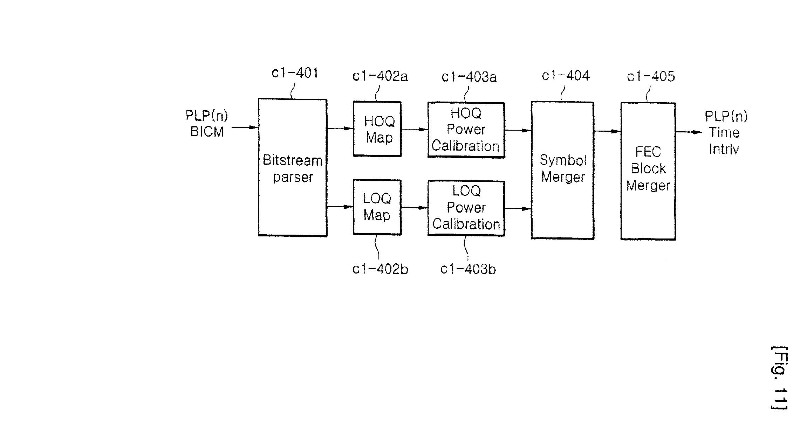

Fig. 11 shows an example of HOQ/LOQ power calibrations applied to QAM mappers using a Hybrid modulation. Bitstream parser (c 1-401) can split inputted bitstreams into HOQ mapper (c1-402a) and LOQ mapper (c1-402b). Power calibrations (c1-403a and c1-403b), which can optimize performance while maintaining a total transmission power, can be performed to the outputted symbol streams from the HOQ mapper (c1-402a) and LOQ mapper (c1-402b). Symbol merger (c1-404) can merge the two symbol streams into a single symbol stream. FEC block merger (c1-405) can merge four of symbol blocks corresponding to 16200 bits into a single symbol block corresponding to 64800 bits when a length of the inputted symbol block is 16,200 bits.

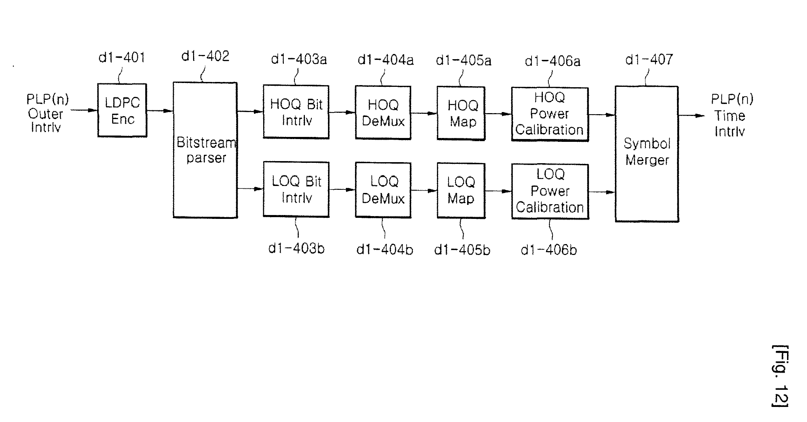

Fig. 12 shows an example of HOQ/LOQ power calibration applied to QAM mapper which is combined with an inner interleaver. LDPC encoded (d1-401) bitstreams can be split into bitstreams by bitstream parser (d1-402) for HOQ and LOQ mapping. Each bitstream can be bit interleaved (d1-403a and d1-403b) and demuxed (d1-404a and d1-404b) and can have characteristics of LDPC codeword and constellation reliability. Each output can be transformed into symbol stream by symbol mapper (d1-405a and d1-405b). An optimum value of power can be applied by the power calibrations (d1-406a and d1-406b) to each QAM. The two symbol streams can be merged into a single symbol stream by the symbol merger (d1-407).

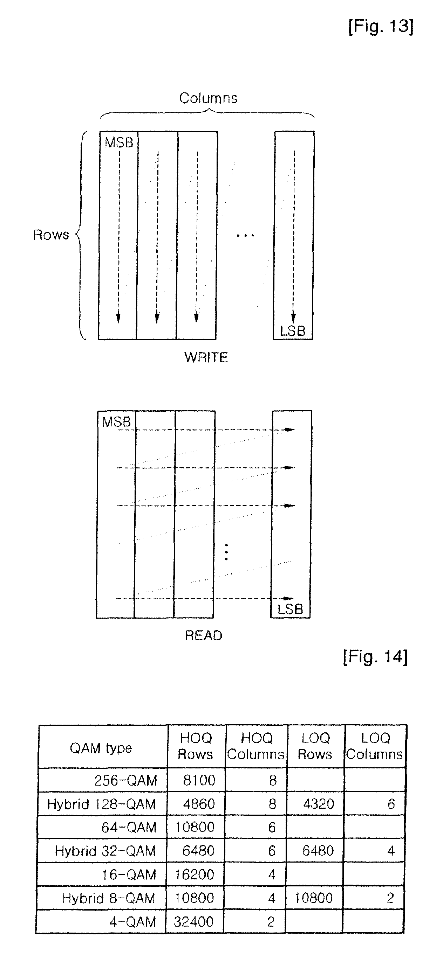

Fig. 13 shows an example of bit interleaving. Bits can be saved into a matrix type memory having columns and rows in the direction of column or in the direction of the blue arrow. Then the saved bits can be read out in the direction of row or in the direction of the red arrow.

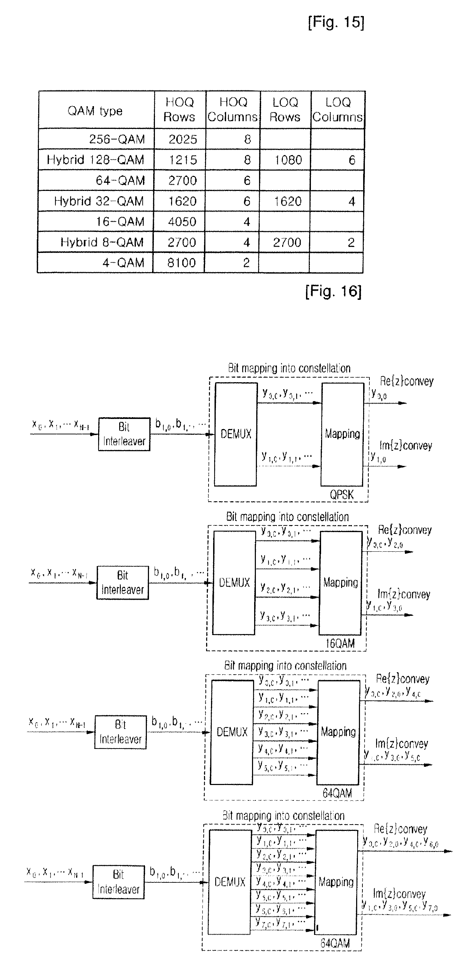

Fig. 14 and 15 show numbers of columns and rows of HOQ bit interleaver (d-403a) and LOQ bit interleaver (d-403b) according to QAM modulation type. As seen in the tables, when a typical even-QAM is used but a hybrid modulation is not used, only HOQ interleaving is used.

Fig. 16 shows an example of the demux. It shows that interleaved outputs according to QPSK, 16-QAM, 64-QAM, and 256-QAM can be demultiplexed and mapped. It also shows that the numbers of output bitstreams from demuxs are 2, 4, 6, and 8 respectively.

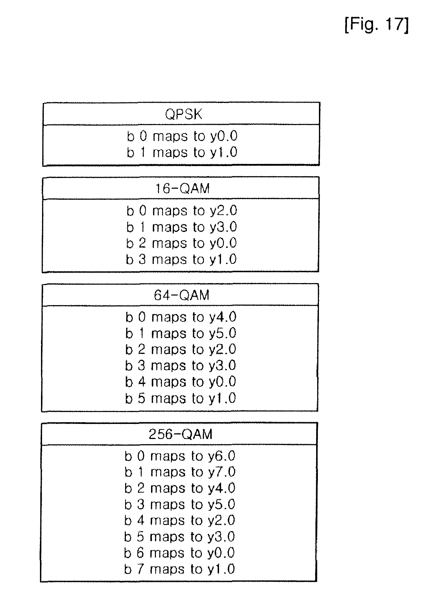

Detail of the demux operation is shown in Fig. 17. As seen in the figure, output order of interleaver can be changed by demux. For example, for the case of 16-QAM, bitstreams can be outputted as j-th output bitstream of each demux according to a value resulting from performing a modulo-4 operation on index of input bitstream b. Fig. 17 shows a relationship between a value resulting from a modulo operation and demux output branch index j.

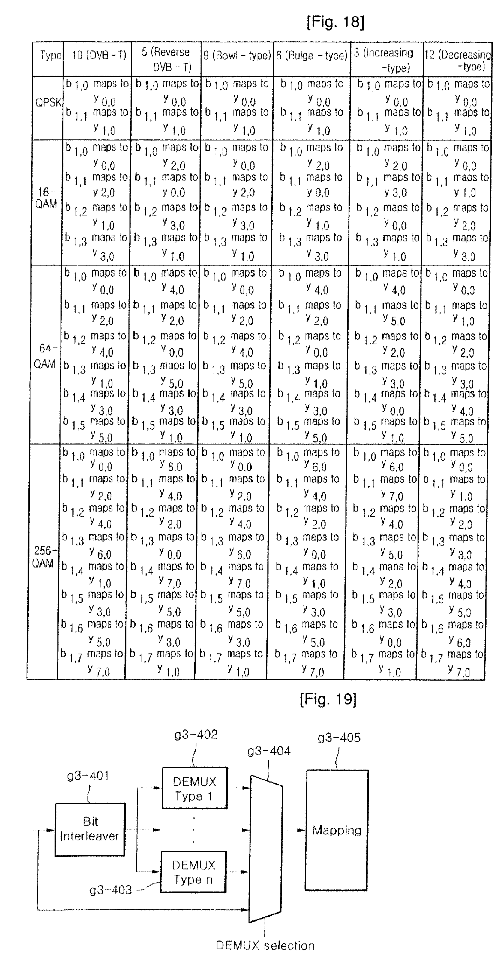

Fig. 18 shows six examples of demultiplexer. Each of the example shows a method of assigning different reliability to bits located in column of bit-interleaver. In other words, y0,0 and y1,0 indicate MSB (Most significant bit) in constellation, thus indicate high reliability. As the number increases, it becomes LSB and indicates low reliability. Six methods are suggested. Those are a mapping method used in DVB-T, an opposite mapping method to the mapping method used in DVB-T, a bowl-type which assigns high priority to each end of column of bit-interleaver, a bulge-type which assigns high priority in the middle of column, an increasing-type which assigns high priority in the right side of column, and a decreasing-type which assigns high priority in the left side of column.

These methods can be useful in an irregular LDPC. In case of the irregular LDPC, reliability of each bit is not identical due to characteristics of H-matrix. Thus, a bit in a particular location has higher reliability, while the other bit in another location has lower reliability. An H-matrix of an LDPC changes as code-rate changes and bit reliability changes as constellation changes. When a bit-interleaver is designed considering these characteristics, reliability of each bit and reliability from H-matrix of LDPC can be combined. Thus, improved robustness against noise can be obtained. Therefore, performance of system using an LDPC can be improved by using the suggested various examples of demultiplexer. In other words, by using varying demultiplexers depending on an LDPC code-rate and a constellation type, system performance can be improved.

In addition, these examples simply relates to a sequence of data being read by bit-interleaver, thus, can reduce or eliminate a physical load to an encoder and a decoder.

Fig. 19 shows an example of a demultiplexer. It is a structure appropriate for being used with FEC which has various characteristics for each code rate such as irregular LDPC. For a case where multiple of optimal demultiplexers for each code rate exist, DEMUX (g3-404) is positioned to utilize all of the demultiplexers (g3-402 and g3-403). In addition, by using DEMUX selection signal, a demultiplexer which is appropriate for a coderate and constellation used in the FEC can be used.

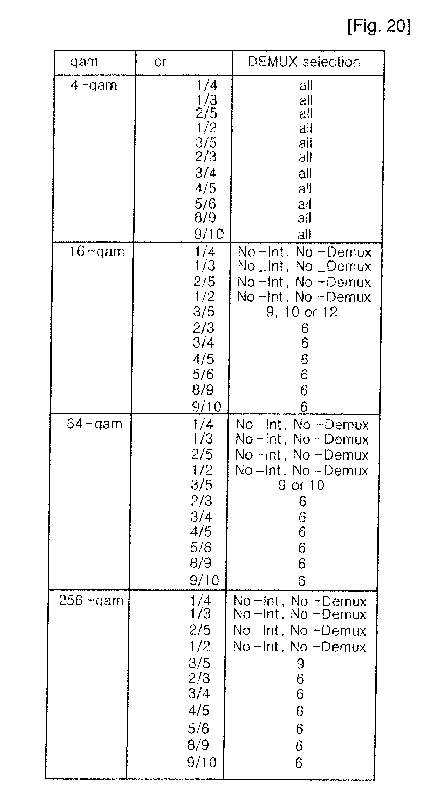

Fig. 20 shows an example of a DEMUX selection signal. This signal is appropriate for an LDPC and a QAM modulation used in DVB-S2. [All] means that all demultiplexer can be used, while [No-int, No-Demux] means signal which didn't go through Bit-interleaver and demultiplexer being used for mapping. The other numbers shown indicate type number of the demultiplexer shown in the Fig. 18.

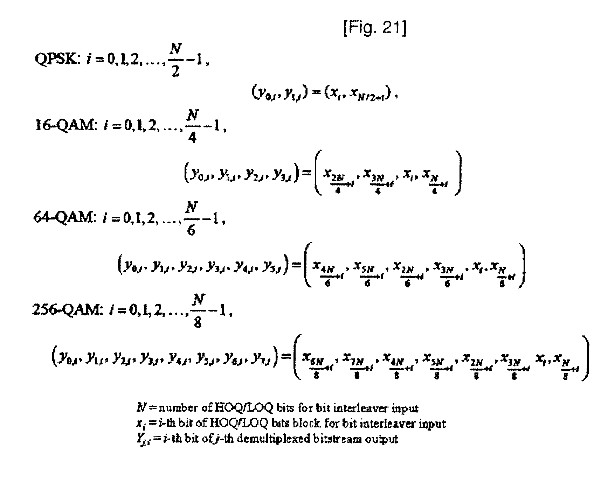

Fig. 21 shows a relationship between an input bitstream of bit interleaver and an output bitstream of demux. As seen in the equations, dividing index of input bitstream by 2, 4, 6, and 8 is a result by the interleaving and mapping each index to index of output bitstream is a result by the demux.

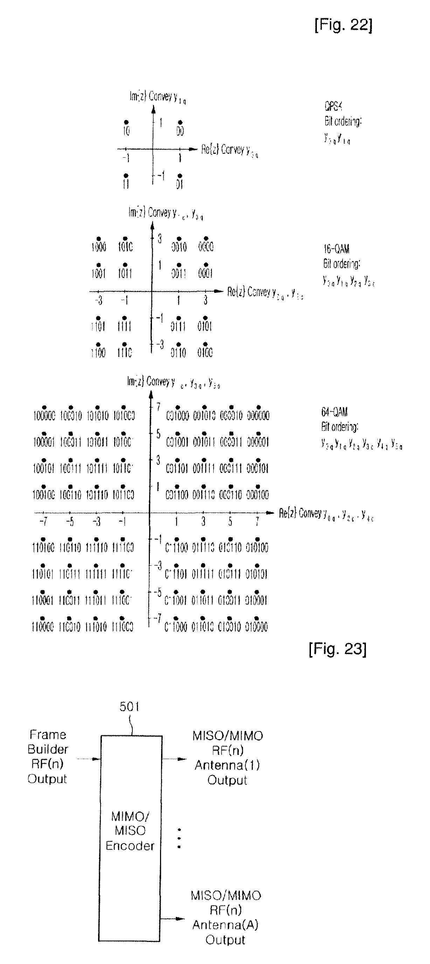

Fig. 22 shows an example of QAM symbol mapping. Output bitstream of demux can be converted into symbolstream by using Gray mapping rule. Even if it is not shown, it can be extended to constellation of 256-QAM or more.

Fig. 23 shows an example of MIMO/MISO Encoder. MIMO/MISO Encoder (501) applies MIMO/MISO method to obtain an additional diversity gain or payload gain. MIMO/MISO Encoder can output signals for total A of antennas. MIMO encoding can be performed individually on total A of antenna signals for each RF band among total R of RF bands. A is equal to or greater than 1.

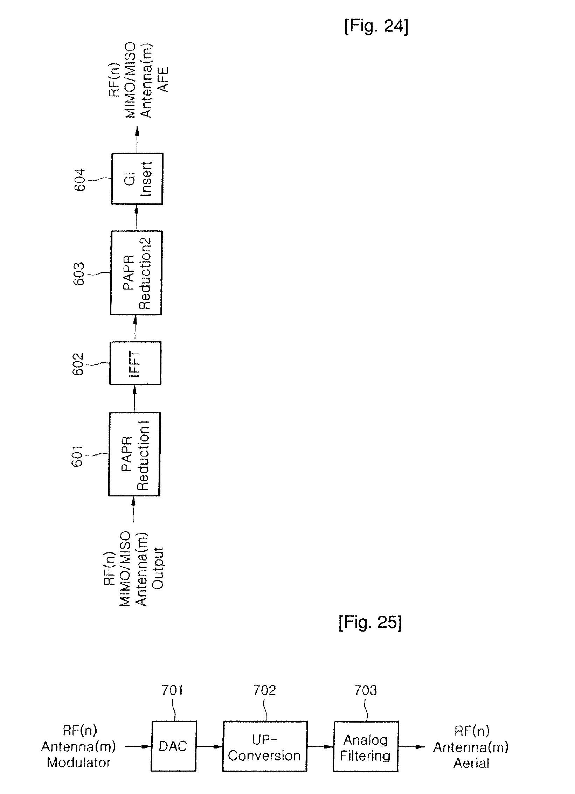

Fig. 24 shows an example of a modulator, specifically an example of an OFDM modulator. PAPR (Peak-to-Average Power Ratio) reduction 1 (601) can be performed on Antenna (m) signals of RF (n) bands. IFFT (602) can be performed for OFDM demodulation. PAPR reduction 2 (603) can be performed after the IFFT. ACE (Active Constellation Extension) and a tone reservation can be used for the PAPR reduction 2 (603). Lastly, guard interval (604) can be inserted.

Fig. 25 shows an example of the analog processor. Output of each modulator can be converted to an analog-domain signal by a DAC (Digital to Analog Conversion) (701), then can be transmitted to antenna after up-conversion (702). Analog filtering (703) can be performed.

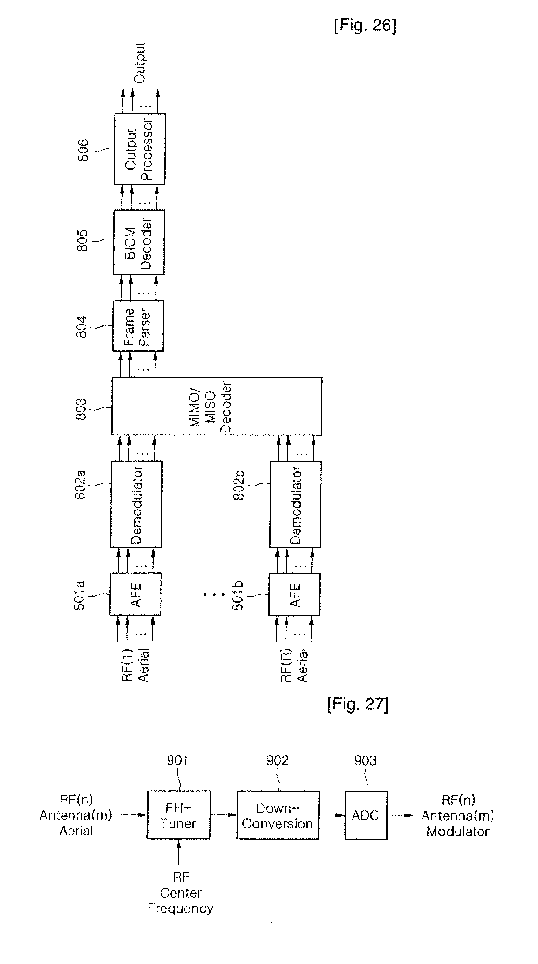

Fig. 26 shows an example of a TFS-OFDM receiver. When total R of RF bands are used for TFS system, received signals by AFE (Analog Front End) (801a,b) can be demodulated by demodulators (802a,b), then can be decoded by MIMO/MISO Decoder (803) to obtain diversity gain. Frame parser (804) can restore multiple PLP signals from received TFS frame. BICM decoder (805) can correct errors in a transmission channel. Finally, output processor (806) can restore signals according to necessary format.

Fig. 27 shows an example of an AFE (Analog Front End). FH (Frequency Hopping)-tuner (901) can perform a frequency hopping and tune signals according to inputted RF center frequency. After down-conversion (902), signals can be converted to digital signals by ADC (Analog to Digital Conversion) (903).

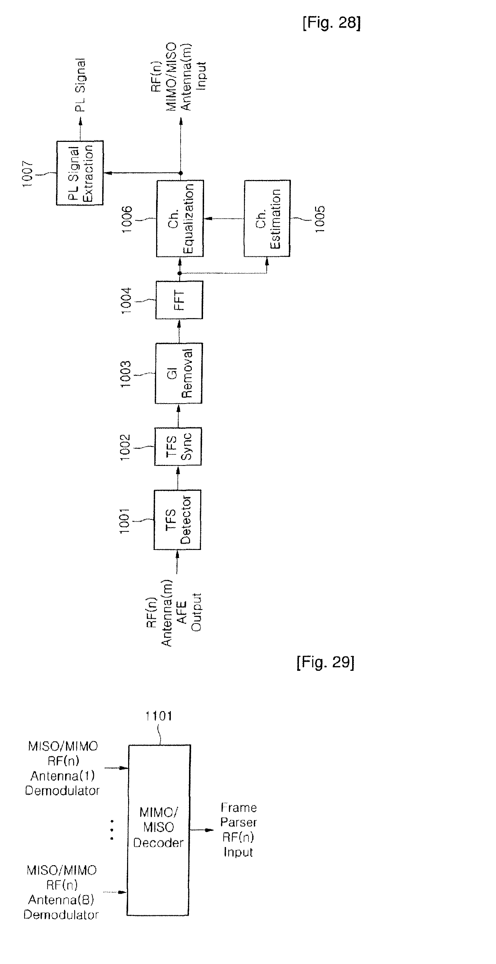

Fig. 28 shows an example of a demodulator, specifically an OFDM demodulator. TFS detector (1001) can detect TFS signals in a received digital signal. TFS sync (1002) can synchronize in time and frequency domains. After GI (Guard Interval) (1003) is removed, symbols in frequency domain can be obtained by performing FFT (1004) for OFDM demodulation. Channel Estimation (1005) can estimate distortion in a transmission channel based on pilot signals. Based on the estimated distortion, Channel Equalization (1006) can compensate distortion in the transmission channel. Finally, PL (Physical Layer) signaling information can be extracted from equalized data and can be transmitted to a system controller.

Fig. 29 shows an example of MIMIO/MISO decoder. Diversity and multiplexing gain can be obtained from data received from total B of antennas. For MIMO, B is greater than 1. For MISO, B is 1.

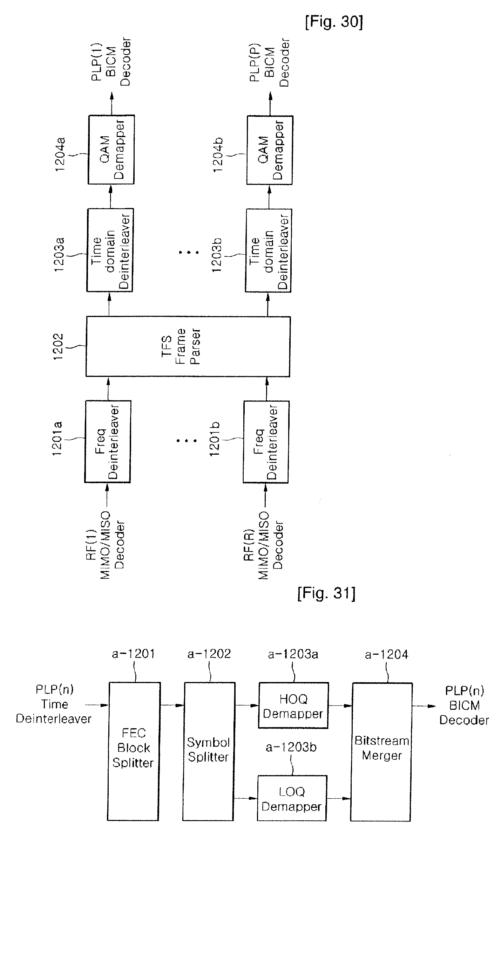

Fig. 30 shows an example of a Frame parser. Total R of the inputted RF bands data can undergo frequency deinterleaving (1201a, b), then can be reconstmcted into datastream by TFS frame parser for each PLP (Physical Layer Path) according to a TFS scheduling. For each PLP, input data for BICM decoder can be obtained by using time domain deinterleaver (1203a, b) and QAM demapper (1204a, b). At this point, hybrid QAM demapper can be used as the QAM demapper.

Fig. 31 shows an example of performing a QAM demapper, which is a counterpart of Fig. 9 of transmitter. FEC block splitter can split inputted symbol block unit having 64800 bits into four symbol blocks of 16200 bits when short DVB-S2 LDPC mode is used. Symbol splitter (a-1202) can split inputted symbol streams into two symbol streams for HOQ and LOQ demapper. HOQ demapper (a-1203a) and LOQ demapper (a-1203b) can perform HOQ and LOQ demapping respectively. Bitstream merger (a-1204) can merge two inputted bit streams into a single output bitstream.

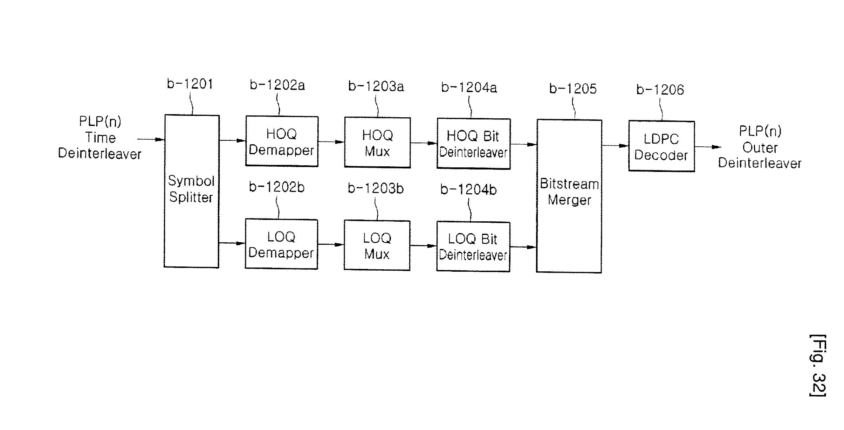

Fig. 32 shows an example of QAM demapper and inner deinterleaver which are counter parts of Fig. 10. Symbol splitter (b-1201) can split output of PLP time deinterleaver into symbol streams for HOQ demapping and LOQ demapping according to hybrid ratio shown in Figs. 5, 6, 7, or 8. Demappers (b-1202a and b-1202b) can transform the symbol streams into bit streams.

Each bitstream can be rearranged by multiplexer (b-1203a, b-1203b), which is a counterpart of the demux of Fig. 10 of transmitter. Two bit deinterleavers (b-1204a and b-1204b) can deinterleave bitstreams according to constellation type. Finally, bitstream merger (b-1205) can merge bitstreams into a single bitstream, then LDPC decoder (b-1206) can correct errors in a transmission channel.

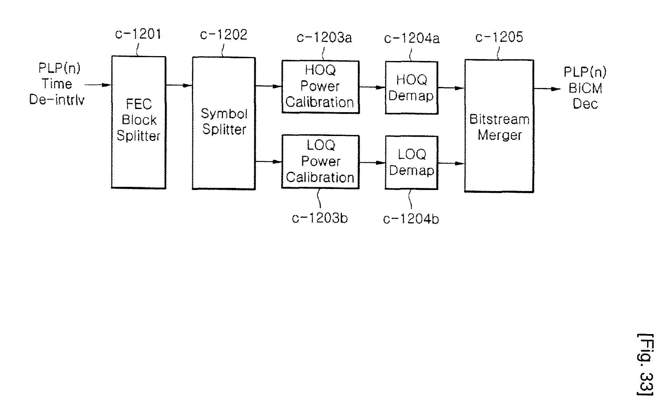

Fig. 33 shows an example of QAM demapper which is a counterpart of the Fig. 11. FEC block splitter can split a symbol block which corresponds to 64,800 bits into four symbol blocks each corresponding to 16,200 bits when a length of the inputted symbol block is 64,800 bits. Symbol splitter (c-1202) can split the inputted symbol streams into symbol streams for HOQ demapping and symbol streams for LOQ demapping. HOQ Power Calibration (c-1203a) and LOQ Power Calibration (c-1203b) can calibrate QAM power and Noise variance by taking into account power applied to QAM at transmitter. HOQ demapper (c-1204a) and LOQ demapper (c-1204b) can perform HOQ demapping and LOQ demapping respectively. Bitstream merger (c-1205) can merge two inputted streams into a single bit stream.

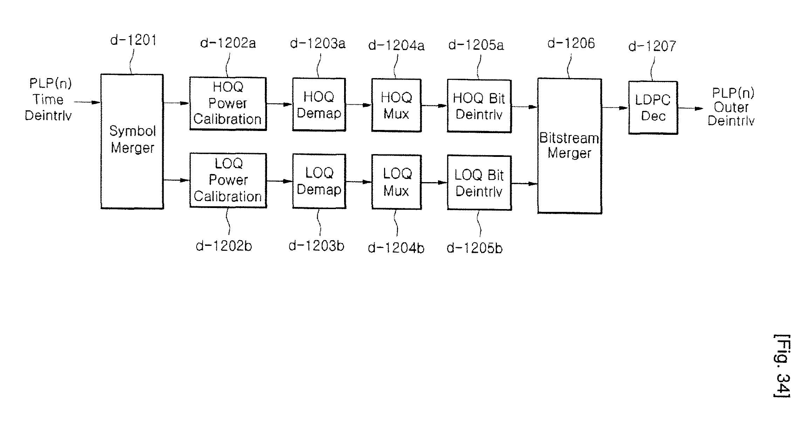

Fig. 34 shows an example of a QAM demapper combined with inner deinterleaver which is a counterpart of the Fig. 12. Symbol splitter (d-1201) can split output from PLP time deinterleaver into two symbol stream for HOQ demapping and LOQ demapping. Power Calibration (d-1202a and d- 1202b) can calibrate QAM power and Noise variance by taking into account power applied to QAM at transmitter. The symbols can be transformed into bit streams by the demapper (d-1203a and d-1203b). Each bit stream can be rearranged by multiplexer (d-1204a and d-1204b) which is an inverse function of demultiplexer shown in Fig. 12. Two bit deinterleavers (d-1205a and d-1205b) can deinterleave the bit stream according to constellation type and code rate. Finally, bitstream merger (d-1206) can merge the bit streams into a single bit stream and the LDPC decoder (d-1207) can correct error in transmission channel.

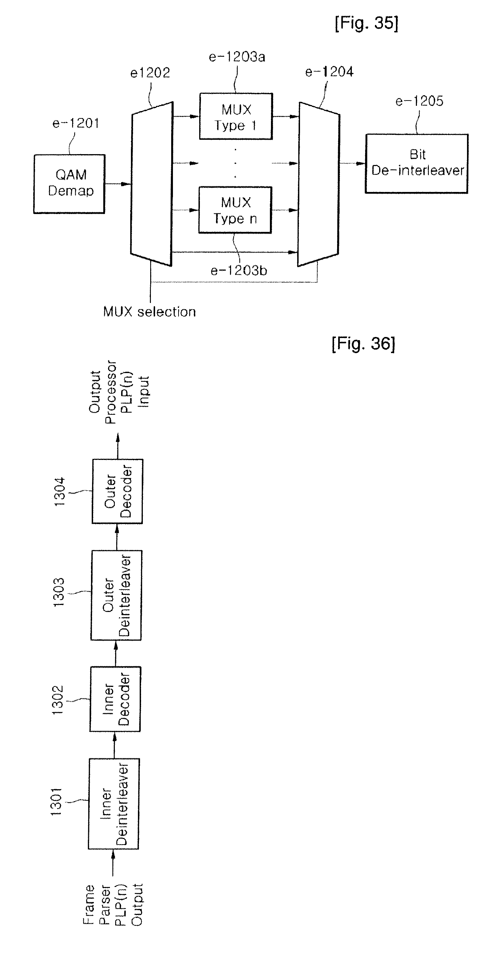

Fig. 35 shows an example of multiplexer which is a counterpart of Fig. 19. In addition, Fig. 35 is an example of multiplexer shown in Fig. 32 (b-1203a and b-1203b) and Fig. 34 (d-1204a and d-1204b). When only even-QAMs (4, 16, 64, 256, 1024-QAM ...) are used, path for either HOQ or LOQ is needed. Suggested structure can include a case where a hybrid modulation and a single QAM are used. QAM demapped (e-1201) bit streams can be controlled to pass the mux which is an inverse function of demux applied at transmitter. To be able to control the bit streams, input and output of mux can be controlled (e-1202 and e-1204) and various forms of mux (e-1203a and e-1203b) can be positioned. Afterwards, the bit streams can be dein-terleaved by bit-deinterleaver (e-1205). This structure is just an example of designing combination of mux which inverses the combination of suggested demux. A part which controls input and output of mux and the mux can be included in a larger mux.

Fig. 36 shows an example of a BICM decoder. Inner deinterleaver (1301) and outer deinterleaver (1303) can convert burst errors in a transmission channel into random errors. Inner decoder (1302) and outer decoder (1304) can correct errors in the transmission channel.

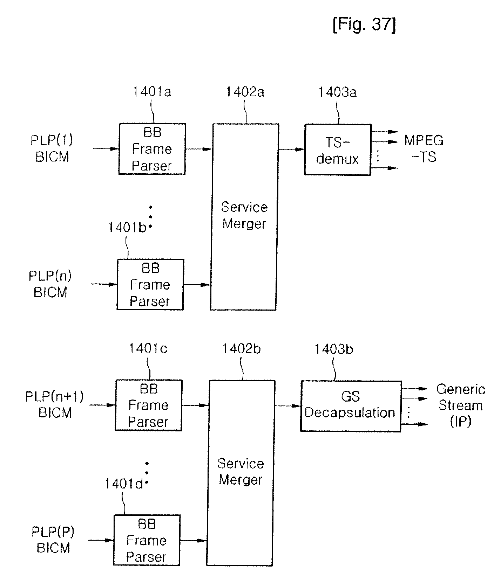

Fig. 37 shows an example of an output processor. BB (Baseband) frame parser (1401a~d) can reconstruct input data into total P of PLP data. Service mergers (1402a, b) can merge data into a single TS (Transport Stream) and a single GSE stream. For TS, TS-demux (1403a) can reconstruct original TS. For GSE stream, GSE De-capsulation (1403b) can reconstruct generic stream.

It will be apparent to those skilled in the art that various modifications and variations can be made in the present invention. Thus, it is intended that the present invention covers the modifications and variations of this invention provided they come within the scope of the appended claims and their equivalents.

[105]

## Claims

1. A transmitter for processing a signal for an OFDM (Orthogonal Frequency Division M ultiplexing) system, the transmitter comprising;
an LDPC (Low Density Parity Check) encoder (303) for encoding a data stream by adding redundancy to the data stream;
a bit-interleaver (g3-401) for bit-interleaving the encoded data stream
a demultiplexer (g3-402~g3~404)) for identifying a type of a demultiplexer according to a code rate and a modulation format and demultiplexing the bit-interleaved data stream according to the identified type of the demultiplexer by changing output order of the bit int erleaved data stream;
a symbol mapper (g3-405) for symbol mapping the demultiplexed data stream according to the modulation format; and
a modulator (105) for modulating the symbol mapped data stream using an OFDM method.

2. The transmitter according to claim 1, wherein the type of the demultiplexer is identified by using a selection signal which is determined by the code rate and the modulation format.

3. The transmitter according to claim 1, wherein the demultiplexing step assigns different reliability to bits located in column of the bit-interleaver.

4. The transmitter according to claim 1, wherein the code rate is an LDPC code rate which is used in the LDPC encoding step.

5. The transmitter according to claim 1, wherein a length of the LDPC encoded data stream is 16,200 bits or 64,800 bits.

6. The transmitter according to claim 1, wherein order of bits in the data stream outputted by the demultiplexer is different from order of bits in the bit-interleaved data stream.

7. A mothod for processing a signal for an OFDM (Orthogonal Frequency Division Multiplexing) system, the method comprising;
LDPC(Low Density Parity Check) encoding a data stream by adding redundancy to the data stream;
bit-interleaving the encoded data stream;
identifying a type of a demultiplexer according to a code rate and a modulation format; demultiplexing the bit-interleaved data stream according to the identified type of the demultiplexer by changing output order of the bit interleaved data stream;
symbol mapping the demultiplexed data stream according to the modulation format; and modulating the symbol mapped data stream using an OFDM method.

8. The method according to claim 7, wherein the type of the demultiplexer is identified by using a selection signal which is determined by the code rate and the modulation format.

9. The method according to claim 7, wherein the demultiplexing step assigns different rel iability to bits located in column of the bit-interleaver.

10. The method according to claim 7, wherein the code rate is an LDPC code rate which is used in the LDPC encoding step.

11. The method according to claim 7, wherein a length of the LDPC encoded data stream is 16,200 bits or 64,800 bits.

12. The method according to claim 7, wherein order of bits in the data stream outputted by the demultiplexing step is different from order of bits in the bit-interleaved data stream.
